# EUROPÄISCHE PATENTANMELDUNG

(11) **EP 2 022 873 A2**
(43) Veröffentlichungstag der Anmeldung: **11.02.2009**
(21) Anmeldenummer: 08104649.2
(22) Anmeldetag: 07.07.2008
(51) Int. Cl.: C23C 18/14

(54) **Verfahren zur Herstellung metallischer Schichten**

(30) Priorität: 07.08.2007 DE 102007037206; 07.04.2008 DE 102008001027
(71) Anmelder: ROBERT BOSCH GMBH, 70442 Stuttgart (DE)
(72) Erfinder: Hebach, Andreas, 71638 Ludwigsburg (DE); Fleischer, Holger, 73529 Schwäbisch Gmünd (DE); Henneken, Lothar, 71638 Ludwigsburg (DE)

(57) **Zusammenfassung**

Die Erfindung betrifft ein Verfahren zur Herstellung von Schichten (5, 7, 9, 11, 13, 15, 17) aus mindestens einem Metall zur Energiewandlung, insbesondere von Schichten (5, 7, 9, 11, 13, 15, 17) für Photovoltaikzellen, bei welchem in einem ersten Schritt mindestens ein Metallkomplex (23) in einem Lösungsmittel gelöst wird und in einem zweiten Schritt eine metallische Schicht (5, 7, 9, 11, 13, 15, 17) durch Freisetzen des Metalls (25) des mindestens einen Metallkomplexes (23) auf einem Träger (1) abgeschieden wird.

## Beschreibung

### Stand der Technik

Die Erfindung betrifft ein Verfahren zur Herstellung von Schichten aus mindestens einem Metall zur Energiewandlung, insbesondere von Schichten für Photovoltaikzellen.

Photovoltaikzellen werden eingesetzt, um Licht in elektrische Energie umzuwandeln. Insbesondere im Rahmen einer nachhaltigen Gestaltung der Zukunft kommt der Solarenergie eine immer zentralere Bedeutung innerhalb der erneuerbaren Energien zu. So hat sich innerhalb von den Jahren die Menge der aus Sonnenenergie gewonnenen elektrischen Energien verhundertfacht.

Bei derzeit eingesetzten Photovoltaikzellen liegt jedoch der Wirkungsgrad bei amorphem Silizium üblicherweise bei 5-10 %. Wenn monokristallines Silizium eingesetzt wird, so steigt der Wirkungsgrad auf 15-20 %. Mehrschichtzellen, die üblicherweise auf Basis von Galliumarsenid aufgebaut sind, weisen mehrere Halbleiterschichten auf, in denen unterschiedliche Wellenlängen absorbiert und in elektrische Energie umgewandelt werden. Bei diesen wird ein Wirkungsgrad von bis zu 25 % erzielt. Das Aufbringen der einzelnen Schichten auf einen Träger erfolgt üblicherweise mittels aus der Halbleitertechnik bekannten Verfahren im Vakuum. Verfahren, die eingesetzt werden, um die Mehrschichtzellen herzustellen, sind z.B. CVD (Chemical Vapor Deposition)-Verfahren. Aufgrund der unter Vakuum durchgeführten Beschichtung sind die derart hergestellten Mehrschichtzellen sehr teuer in der Produktion.

Ein Verfahren zur Herstellung einer photovoltaischen Vorrichtung ist z.B. aus US 5,370,747 bekannt. Hierbei sind einzelne Schichten, umfassend eine p-Halbleiterschicht, ein n-Halbleiterschicht und eine zwischenliegende photoaktive Schicht, von zwei Elektrodenschichten umschlossen. Um den Wirkungsgrad zu steigern, weist die untere Elektrodenschicht eine Textur auf, durch die ein Teil des Lichts gestreut und in die photoelektrische Umwandlungsschicht reflektiert wird. Das Auftragen der Schichten erfolgt z.B. durch Sputtern oder CVD (Chemical Vapor Deposition) bei Umgebungsdruck. Alternativ wird auch ein Plasma-CFD (Chemical Fluid Deposition)-Verfahren zur Herstellung der Schichten genannt. Nachteil des Plasma-CFD-Verfahrens ist der hohe Energiebedarf, der zur Erzeugung des Plasmas erforderlich ist.

### Offenbarung der Erfindung

### Vorteile der Erfindung

Ein erfindungsgemäßes Verfahren zur Herstellung mindestens einer Schicht aus mindestens einem Metall zur Energiewandlung, insbesondere von mindestens einer metallischen Schicht für Photovoltaikzellen, umfasst folgende Schritte:
(a) Lösen mindestens eines komplex, kovalent oder ionisch gebundenen Metalls als Zielatome in einem Lösungsmittel,
(b) Abscheiden einer metallischen Schicht durch Freisetzen der Zielatome auf einem Träger.

Das erfindungsgemäße Verfahren ermöglicht es, Photovoltaikzellen mit einem hohen Wirkungsgrad kostengünstig herzustellen.

Erfindungsgemäß umfasst der Begriff Metalle auch Halbmetalle. Insbesondere sind unter Metallen Ruthenium, Palladium, Platin, Gallium, Arsen, Titan, Cadmium, Zink, Indium, Tellur, Kupfer oder Molybdän zu verstehen. Halbmetalle sind zum Beispiel Phosphor, Schwefel oder Selen. Diese Metalle und Halbmetalle sind die Zielatome zur Ausbildung der metallischen Schicht. Die Zielatome können komplex gebunden, kovalent gebunden oder ionisch gebunden vorliegen. Ein Beispiel für komplex gebundene Zielatome ist Me(thd)₃, für kovalent gebundene Me(Alkyl)₂ und für ionisch gebundene ZnS.

Der Träger, auf den der Metallkomplex abgeschieden wird, ist üblicherweise ein elektrisch leitendes Substrat. Im Allgemeinen wird ein Glasträger verwendet, der mit Molybdän bedampft ist. Es eignet sich aber auch jeder andere, dem Fachmann bekannte Träger, der mindestens eine elektrisch leitfähige Schicht aufweist und zur Herstellung von Photovoltaikzellen verwendet werden kann.

Der Metallkomplex, der eingesetzt wird, ist vorzugsweise ausgewählt aus Me(acac)₃, Me(thd)₃, Me(thd)₂COD, Me(cp)₂, Me(allyl)₂COD oder Me(CH₃)₂COD, wobei
- Me: ein Metall, ausgewählt aus Ruthenium, Palladium, Platin, Gallium, Arsen, Titan, Cadmium, Zink, Indium, Tellur, Kupfer oder Molybdän,
- acac: Acetylacetonat,
- cp: Cyclopentadien,
- allyl: Propen,
- COD: 1,5-Cyclooctadien und
- thd: 2,2,6,6-Tetramethyl-3,5-Heptandionat
bedeuten.

In einer weiteren bevorzugten Ausführungsform ist das Metall ausgewählt aus Tellur oder Selen. Bevorzugte Liganden zur Bildung des Metallkomplexes sind in diesem Fall Thiolat-Liganden, Diaryl-Liganden, Dialkyl-Liganden sowie Thioharnstoff-Derivate. Geeignete Thiolat-Liganden sind zum Beispiel SCH₃, SC₂H₅, SCH₂C₆H₅. Die Liganden zur Bildung des Metallkomplexes sind gegenüber energetischer Strahlung metastabil, so dass durch Aufbringen einer energiereichen Strahlung das Tellur bzw. Selen freigesetzt und auf dem Träger abgeschieden werden kann. Durch das Freisetzen des Tellurs bzw. Selens entsteht im Allgemeinen ein Disulfid. Bei Einsatz von SCH₃ als Ligand ist dies zum Beispiel H₃CSSCH₃. Das Disulfid kann auf einfache Weise abgetrennt werden und gegebenenfalls nach wenigen Aufarbeitungsschritten erneut zur Synthese des Metallkomplexes, beispielsweise von Se(SCH₃)₂ eingesetzt werden.

Das Lösungsmittel, in dem der Metallkomplex in Schritt (a) vorzugsweise gelöst wird, ist überkritisches Kohlendioxid. Alternativ eignen sich als Lösungsmittel zum Beispiel auch überkritisches SF6, überkritisches Perfluorethan, sowie unpolare geradkettige, verzweigte oder cyclische Alkyl-Lösungsmittel, vorzugsweise mit 6 bis 10 C-Atomen, sowie aromatische Lösungsmittel, wie Benzol, Toluol oder Xylol, und Lösungsmittel, die im Wesentlichen gleiche Löslichkeitseigenschaften wie vorstehend genannte Lösungsmittel aufweisen.

Wenn als Lösungsmittel überkritisches Kohlendioxid eingesetzt wird, so liegt vorzugsweise ein Druck im Bereich von 50-350 bar, insbesondere ein Druck im Bereich von 100-250 bar vor. Die Temperatur, bei der der Metallkomplex in Lösungsmittel gelöst wird, liegt vorzugsweise im Bereich von 20 bis 300 °C.

In einer ersten Ausführungsform des erfindungsgemäßen Verfahrens erfolgt das Abscheiden der metallischen Schicht durch Freisetzen des Metalls des mindestens einen Metallkomplexes in Schritt (b) durch Wärmezufuhr auf eine Temperatur oberhalb der Zersetzungstemperatur des Metallkomplexes. Üblicherweise wird hierzu der Träger auf die erforderliche Temperatur erwärmt. Die Temperatur, auf die der Träger erwärmt wird, liegt üblicherweise im Bereich von 20-300 °C. Wenn als Metallkomplex z.B. Me(thd)₃ eingesetzt wird, erfolgt die Abscheidung der metallischen Schicht z.B. bei einer Temperatur von 200 °C und einem Druck von 170 bar. Bei Me(thd)₂ COD erfolgt die Abscheidung der metallischen Schicht z.B. bei einer Temperatur von ungefähr 200 °C und einem Druck von 189 bar. Die Abscheidung der metallischen Schicht bei Verwendung von Me(CH₃)₂COD erfolgt vorzugsweise bei einer Temperatur im Bereich von 70 bis 90 °C und einem Druck im Bereich von 140 bis 170 bar.

Das Erwärmen des Trägers erfolgt durch jede beliebige, dem Fachmann bekannte Wärmequelle. So ist es z.B. möglich, den Träger in einem konventionellen Ofen, einem Induktionsofen, einem Konvektionsofen oder durch Infrarotstrahlung, durch Mikrowellen, NIR-Strahlung oder Laserstrahlung zu erwärmen.

In einer zweiten Ausführungsform des erfindungsgemäßen Verfahrens erfolgt das Freisetzen des Metalls aus dem mindestens einen Metallkomplex durch Reaktion mit einem Reduktionsmittel. Ein geeignetes Reduktionsmittel ist z.B. Wasserstoff. Weitere geeignete Reduktionsmittel sind z.B. auch Verbindungen, die Wasserstoff freisetzen, sowie Metallkomplexe mit intrinsischer Redoxreaktion oder auch der Zusatz von molekularem Wasserstoff.

Zur Freisetzung des Metalls durch Reaktion mit einem Reduktionsmittel, insbesondere mit Wasserstoff eignet sich z.B. Me(CH₃)₂COD. Weitere Metallkomplexe bei denen das Metall durch Reaktion mit einem Reduktionsmittel freigesetzt werden kann, sind z.B. Metall-O-Komplexe, zum Beispiel Me(bis(1,4-isobutylbutadien)).

In einer dritten Ausführungsform des erfindungsgemäßen Verfahrens erfolgt das Freisetzen des Metalls durch Lichteinstrahlung. Hierbei ist entweder eine gezielte Erwärmung des Trägers durch eine Lichtquelle denkbar oder es erfolgt eine photokatalytisch gesteuerte Reaktion, durch die das Metall freigesetzt wird. Wenn der Träger durch die Lichteinstrahlung erwärmt wird, so ist eine Erwärmung auf eine Temperatur oberhalb der Zersetzungstemperatur des Metallkomplexes erforderlich, damit das Metall freigesetzt wird. In diesem Fall erfolgt das Freisetzen des Metalls analog zur ersten Ausführungsform, bei der der Träger erwärmt wird.

Obige Komplexe absorbieren energetische Strahlung und können zerfallen.

Als energetische Strahlung bei Einsatz von Thiolat-Liganden, Diaryl-Liganden, Dialkyl-Liganden oder Thioharnstoff-Derivaten, insbesondere in Tellur-Komplexen bzw. Selen-Komplexen wird als energetische Strahlung zur Freisetzung des Tellurs bzw. Selens vorzugsweise UV-Strahlung, NIR-Strahlung oder IR-Strahlung eingesetzt.

Nach dem Abscheiden der metallischen Schicht durch Freisetzen des Metalls aus dem mindestens einen Metallkomplex auf dem Träger, werden die frei gewordenen Liganden durch das Lösungsmittel abtransportiert. Es verbleibt eine reine Metallschicht auf dem Träger. Wenn auf dem Träger eine Schicht aus mehreren unterschiedlichen Metallen abgeschieden werden soll, so werden vorzugsweise mehrere Metallkomplexe der verschiedenen Metalle gelöst. Der Anteil der einzelnen Metallkomplexe entspricht dabei dem Anteil, den das Metall später in der metallischen Schicht einnehmen soll. Geeignete Schichten, die aus Mischungen oder Legierungen mehrerer Metalle gefertigt sind, sind z.B. CdS, ZnSe, GaAs, CdTe.

In einer besonders bevorzugten Ausführungsform werden durch das erfindungsgemäße Verfahren mehrere Schichten hergestellt. Hierzu wird vorzugsweise nach dem Abscheiden der metallischen Schicht in Schritt (b) mindestens eine weitere metallische Schicht durch Abscheidung und Freisetzung des Metalls mindestens eines weiteren Metallkomplexes auf die metallische Schicht aufgetragen. Damit mehrere unterschiedliche Schichten entstehen, unterscheiden sich die Metallkomplexe der weiteren Schichten von den zuvor aufgetragenen. So können z.B. Schichten aus anderen Metallen oder Schichten aus den gleichen Metallen aber in einer anderen Zusammensetzung aufgetragen werden. Dabei bedeutet Schichten aus den gleichen Metallen aber in einer anderen Zusammensetzung, dass sich die Anteile der einzelnen Metalle in der Schicht unterscheiden.

Ein weiterer Vorteil des erfindungsgemäßen Verfahrens ist es, dass durch Blendentechnik auch 2D-Strukturen zugänglich sind, die durch herkömmliche Verfahren, das heißt beispielsweise durch chemische oder physikalische Aufdampfverfahren, nicht direkt dargestellt werden können.

### Kurze Beschreibung der Zeichnungen

Ausführungsformen der Erfindung sind in den Zeichnungen dargestellt und werden in der nachfolgenden Beschreibung näher erläutert.

Es zeigen:
- Figur 1: Einen schematischen Aufbau einer mehrschichtigen Photovoltaikzelle,
- Figur 2: eine schematische Darstellung des erfindungsgemäßen Verfahrens in einer ersten Ausführungsform,
- Figur 3: eine schematische Darstellung des erfindungsgemäßen Verfahrens in einer zweiten Ausführungsform,
- Figur 4: eine schematische Darstellung des erfindungsgemäßen Verfahrens in einer dritten Ausführungsform.

### Ausführungsformen der Erfindung

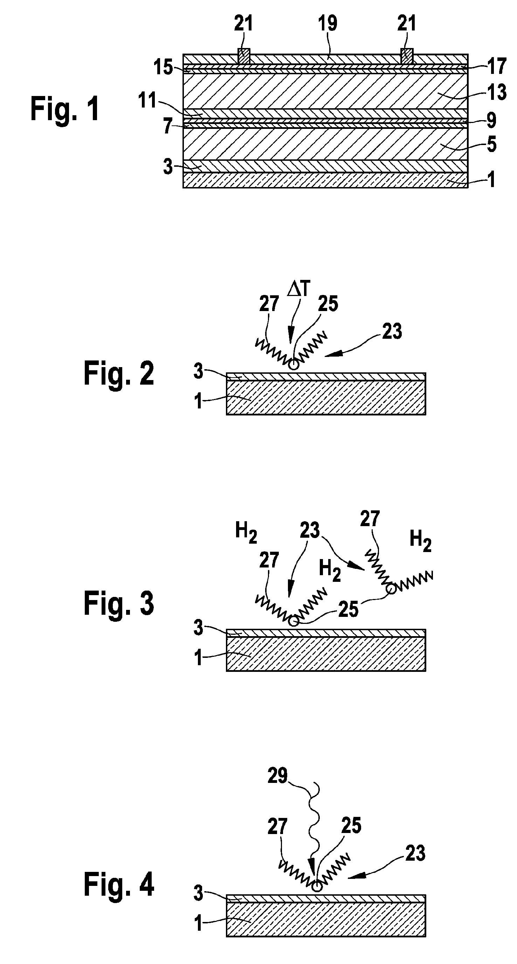

In Figur 1 ist schematisch ein Mehrschichtaufbau für eine Photovoltaikzelle dargestellt.

Auf einem Träger 1 ist eine Metallschicht 3 aufgebracht. Die Metallschicht 3 ist elektrisch leitend. Üblicherweise ist der Träger 1 ein Glasträger und die Metallschicht 3 Molybdän, das auf den Träger 1 aufgedampft ist. An die Metallschicht 3 schließt eine erste p-Halbleiterschicht 5 an. Die erste p-Halbleiterschicht 5 ist vorzugsweise aktiv für längerwelliges Licht, z.B. für rotes Licht 6. Geeignetes Material für die erste p-Halbleiterschicht ist z.B. p-CulnSe₂. Um das einstrahlende Licht in elektrische Energie umwandeln zu können, schließt sich an die p-Halbleiterschicht 5 eine erste n-Halbleiterschicht 7 an. Auf die erste n-Halbleiterschicht 7 ist eine erste n⁺-Halbleiterschicht 9 aufgebracht.

Im Mehrschichtaufbau schließt sich daran eine zweite aktive Schicht an. Die zweite aktive Schicht umfasst eine erste p⁺-Halbleiterschicht 11 sowie eine zweite p-Halbleiterschicht 13. Hieran schließt sich wiederum eine zweite n-Halbleiterschicht 15 sowie eine zweite n⁺-Halbleiterschicht 17 an. Die zweite aktive Schicht ist üblicherweise für kürzerwelliges Licht aktiv. Bei einer Zweischicht-Photovoltaikzelle, wie sie in Figur 1 dargestellt ist, bei der die erste aktive Schicht für rotes Licht 6 aktiv ist, ist die zweite aktive Schicht üblicherweise für blaues Licht 18 aktiv. Hierzu ist die erste p⁺-Halbleiterschicht 11 vorzugsweise eine p⁺-CuₓGa_{y}Se₂-Schicht und die zweite p-Halbleiterschicht 13 eine p-CuGaSe₂-Schicht. Die Schichtdicken der ersten p-Halbleiterschicht 5 und der zweiten p-Halbleiterschicht 13 liegen vorzugsweise in einem Bereich zwischen 1 und 3 µm.

Bei dem Zweischichtaufbau, bei dem die erste aktive Schicht für rotes Licht 6 aktiv ist und die zweite aktive Schicht für blaues Licht 18, sind die erste n-Halbleiterschicht und die zweite n-Halbleiterschicht vorzugsweise Schichten aus n-ZnSe und die erste n⁺-Halbleiterschicht 9 sowie die zweite n⁺-Halbleiterschicht 17 Schichten aus n⁺-ZnO.

Der Schichtaufbau der zweiten aktiven Schicht, d.h. der dem Träger 1 abgewandten Schicht, auf die das Licht auftrifft, ist vorzugsweise durchlässig für Wellenlängen, die in die erste aktive Schicht eindringen sollen.

Die zweite n⁺-Halbleiterschicht 17 ist durch eine Anti-Reflex-Schicht 19 abgedeckt. Durch die Anti-Reflex-Schicht 19 wird vermieden, dass das einstrahlende Licht reflektiert wird. Dies führt dazu, dass das einstrahlende Licht von der Photovoltaikzelle absorbiert wird und so in elektrische Energie umgewandelt werden kann. Um einen Stromkreis ausbilden zu können, sind üblicherweise in der Anti-Reflex-Schicht 19 elektrische Leiter 21 enthalten. Im Allgemeinen haben die elektrischen Leiter 21 eine gitterförmige Struktur.

In Figur 2 ist schematisch das erfindungsgemäße Verfahren zur Herstellung einer metallischen Schicht in einer ersten Ausführungsform dargestellt.

Die Beschichtung erfolgt hierbei mit Hilfe eines CFD-Verfahren (Chemical Fluid Deposition). Hierzu wird in einem Fluid, vorzugsweise in überkritischem Kohlendioxid, d.h. Kohlendioxid bei einem Druck im Bereich 30 und 350 bar und einer Temperatur im Bereich von 20 bis 300 °C mindestens ein Metallkomplex 23 gelöst. Der Metallkomplex 23 wird mit dem Fluid an die Oberfläche des Trägers 1, auf den die Metallschicht 3 aufgebracht ist, transportiert. Auf der Metallschicht 3 wird das Metall 25 des Metallkomplexes 23 abgeschieden. Hierzu werden die Liganden 27 des Metallkomplexes 23 vom Metall 25 abgespaltet. In der in Figur 2 dargestellten Ausführungsform erfolgt das Abspalten der Liganden 27 vom Metall 25 durch Wärmezufuhr. Dies ist durch den mit ΔT bezeichneten Pfeil dargestellt.

Das Metall 25 des Metallkomplexes ist, wie vorstehend beschrieben, vorzugsweise ausgewählt aus Ruthenium, Palladium, Platin, Gallium, Arsen, Titan, Cadmium, Zink, Indium, Kupfer oder Molybdän. Geeignete Liganden 27, die zusammen mit dem Metall 25 den Metallkomplex 23 bilden, sind z.B. Acetylacetonat, Cyclopentadien, Propen, 1,5-Cyclooctadien, 2,2,6,6-Tetramethyl-3,5-Heptandionat oder eine Methyl-Gruppe.

In einer weiteren bevorzugten Ausführungsform ist das Metall 25 des Metallkomplexes ausgewählt aus Tellur und Selen. Geeignete Liganden 27 sind in diesem Fall Thiolat-Liganden, zum Beispiel SCH₃, SC₂H₅ oder SCH₂C₆H₅, Diaryl-Liganden, Dialkyl-Liganden sowie Thioharnstoff-Derivate.

Die bei der Freisetzung des Metalls 25 zur Herstellung der metallischen Schicht auf dem Träger 1 freigesetzten Liganden 27 werden mit dem Fluid, vorzugsweise dem überkritischen Kohlendioxid, vom Träger 1 entfernt. Durch das Verfahren lässt sich auf einfache Weise eine gezielte Schichtdicke der metallischen Schicht, die durch das erfindungsgemäße Verfahren hergestellt wird, einstellen. So ist es durch das erfindungsgemäße Verfahren sogar möglich, monomolekulare Schichten herzustellen.

Die Wärmezufuhr bei der in Figur 2 dargestellten Ausführungsform erfolgt auf jede beliebige, dem Fachmann bekannte Art. So kann die Wärmezufuhr z.B. durch einen Ofen erfolgen. Weiterhin ist es auch möglich, den Träger 1 z.B. durch Mikrowellen, IR-Strahlung oder durch Induktion zu erwärmen. Weitere geeignete Möglichkeiten der Wärmezufuhr sind zum Beispiel auch Mikrowellen, NIR-Strahlung, UV-Strahlung oder Laserstrahlung.

In Figur 3 ist eine alternative Ausführungsform des erfindungsgemäßen Verfahrens dargestellt.

Die in Figur 3 dargestellte Ausführungsform unterscheidet sich von der in Figur 2 dargestellten Ausführungsform dadurch, dass das Freisetzen des Metalls aus den Metallkomplexen 23 nicht nur durch Wärmezufuhr erfolgt, sondern zusätzlich durch Reaktion mit einem Reduktionsmittel. Als Reduktionsmittel wird bei der in Figur 2 dargestellten Ausführungsform Wasserstoff eingesetzt. Die Liganden 27 reagieren mit dem Wasserstoff und lösen sich so aus dem Metallkomplex 23. Auf diese Weise wird das Metall auf der Metallschicht 3 zur metallischen Schicht abgeschieden. Der Wasserstoff kann zum Beispiel durch eine chemische Reaktion im Reaktor freigesetzt werden, z.B. durch Zugabe von Hydrazin oder Metallhydrid oder als Impuls dem Reaktionsgemisch zugesetzt werden.

Eine dritte Ausführungsform des erfindungsgemäßen Verfahrens ist in Figur 4 dargestellt. Bei der in Figur 4 dargestellten Ausführungsform erfolgt das Freisetzen des Metalls 25 aus dem Metallkomplex 23 durch Zugabe von Licht 29. Hierbei ist es einerseits möglich, dass wie bei der in Figur 2 dargestellten Ausführungsform durch das Licht 29 der Träger 1 mit der darauf aufgebrachten Metallschicht 3 erwärmt wird auf ein Temperatur oberhalb der Zersetzungstemperatur des Metallkomplexes 23, so dass die Liganden 27 vom Metall 25 abgetrennt werden und das Metall 25 sich auf der Metallschicht 3 abscheidet. Alternativ ist es jedoch auch möglich, dass durch das Licht 29 eine photokatalytisch aktivierte Reaktion gestartet wird, durch welche die Liganden 27 vom Metall 25 abgetrennt werden. Eine solche photokatalytisch aktivierte Reaktion umfasst zum Beispiel einen radikalischen Mechanismus.

In den Figuren 2 bis 4 ist jeweils exemplarisch die Abscheidung einer ersten metallischen Schicht auf der Metallschicht 3 dargestellt. Erfindungsgemäß lässt sich durch das gleiche Verfahren auch jede weitere Schicht der Photovoltaikzelle herstellen. In diesem Fall erfolgt die Abscheidung und Freisetzung des Metalls 25 aus den Metallkomplexen 23 nicht auf der Metallschicht 3 sondern auf der jeweils obersten metallischen Schicht 5, 7 , 9, 11, 13, 15, 17. Die Dicke der einzelnen Schichten, 5, 7, 9, 11, 13, 15, 17, 19 lässt sich durch die Dauer der CFD-Beschichtung bzw. durch die Konzentration der Metallkomplexe 23 im Fluid, vorzugsweise dem überkritischen Kohlendioxid, einstellen. Wenn die Schicht aus mehr als nur einem Metall bestehen soll, z.B. eine Mischung mehrerer Metalle oder eine Legierung, werden im Fluid verschiedene Metallkomplexe mit unterschiedlichen Metallen, die die metallische Schicht bilden sollen, gelöst. Der Anteil der einzelnen Metallkomplexe der unterschiedlichen Metalle entspricht dem Anteil, den die einzelnen Metalle in der metallischen Schicht einnehmen sollen.

## Patentansprüche

1. Verfahren zur Herstellung von Schichten (5, 7, 9, 11, 13, 15, 17) aus mindestens einem Metall zur Energiewandlung, insbesondere von Schichten (5, 7, 9, 11, 13, 15, 17) für Photovoltaikzellen, folgende Schritte umfassend:
(a) Lösen mindestens eines komplex, kovalent oder ionisch gebundenen Metalls (23) als Zielatome in einem Lösungsmittel,
(b) Abscheiden einer metallischen Schicht (5, 7, 9, 11, 13, 15, 17) durch Freisetzen der Zielatome auf einem Träger (1).

2. Verfahren nach Anspruch 1, **dadurch gekennzeichnet, dass** die Zielatome ausgewählt sind aus Ruthenium, Palladium, Platin, Gallium, Arsen, Titan, Cadmium, Zink, Indium, Tellur, Kupfer, Molybdän, Phosphor, Schwefel und Selen.

3. Verfahren nach Anspruch 1 oder 2, **dadurch gekennzeichnet, dass** das Lösungsmittel komprimiertes Kohlendioxid ist.

4. Verfahren nach Anspruch 3, **dadurch gekennzeichnet, dass** das Kohlendioxid bei einem Druck im Bereich von 50 bis 350 bar vorliegt.

5. Verfahren nach Anspruch 1 oder 2, **dadurch gekennzeichnet, dass** das Lösungsmittel ausgewählt ist aus unpolaren geradkettigen, verzweigten oder cyclischen Alkyl-Lösungsmitteln, vorzugsweise mit 6 bis 10 C-Atomen, sowie aromatischen Lösungsmitteln, wie Benzol, Toluol und Xylol, oder aus Lösungsmitteln, die im Wesentlichen gleiche Löslichkeitseigenschaften aufweisen wie diese Lösungsmittel.

6. Verfahren nach einem der Ansprüche 1 bis 5, **dadurch gekennzeichnet, dass** das Freisetzen des Metalls (25) durch Wärmezufuhr auf eine Temperatur oberhalb der Zersetzungstemperatur des Metallkomplexes (23) erfolgt.

7. Verfahren nach einem der Ansprüche 1 bis 5, **dadurch gekennzeichnet, dass** das Freisetzen des Metalls (25) durch Reaktion mit einem Reduktionsmittel erfolgt.

8. Verfahren nach Anspruch 7, **dadurch gekennzeichnet, dass** das Reduktionsmittel physikalisch oder chemisch gelöster Wasserstoff ist.

9. Verfahren nach einem der Ansprüche 1 bis 5, **dadurch gekennzeichnet, dass** das Freisetzen des Metalls (25) durch Lichteinstrahlung (29) erfolgt.

10. Verfahren nach Anspruch 9, **dadurch gekennzeichnet, dass** durch die Lichteinstrahlung (29) der Träger (1) auf eine Temperatur oberhalb der Zersetzungstemperatur des Metallkomplexes (23) erwärmt wird.

11. Verfahren nach Anspruch 9, **dadurch gekennzeichnet, dass** durch die Lichteinstrahlung (29) eine photokatalytisch aktivierte Reaktion zur Freisetzung des Metalls (25) gestartet wird.

12. Verfahren nach einem der Ansprüche 1 bis 11, **dadurch gekennzeichnet, dass** der Metallkomplex (23) ausgewählt ist aus Me(acac)₃, Me(thd)₃, Me(thd)₂COD, Me(cp)₂, Me(allyl)₂COD oder Me(CH₃)₂COD, wobei
Me ein Metall, ausgewählt aus Ruthenium, Palladium, Platin, Gallium, Arsen, Titan, Cadmium, Zink, Indium, Tellur, Kupfer oder Molybdän,
acac Acetylacetonat,
cp Cyclopentadien,
allyl Propen,
COD 1,5-Cyclooctadien und
thd 2,2,6,6-Tetramethyl-3,5-Heptandionat
bedeuten.

13. Verfahren nach einem der Ansprüche 1 bis 11, **dadurch gekennzeichnet, dass** das Metall (25) des Metallkomplexes (23) Tellur oder Selen ist und die Liganden (27) Thiolat-Liganden, Diaryl-Liganden, Dialkyl-Liganden oder Thioharnstoff-Derivate sind.

14. Verfahren nach einem der Ansprüche 1 bis 13, **dadurch gekennzeichnet, dass** nach dem Abscheiden der metallischen Schicht (5) in Schritt (b) auf der Metallschicht (3) mindestens eine weitere metallische Schicht (7, 9, 11, 13, 15, 17) durch Abscheidung und Freisetzung des Metalls (25) mindestens eines weiteren Metallkomplexes (23) auf die metallische Schicht (5, 7, 9, 11, 13, 15, 17) aufgetragen wird.
